# EUROPEAN PATENT APPLICATION

(11) **EP 2 312 565 A2**
(43) Date of publication of application: **20.04.2011**
(21) Application number: 10187198.6
(22) Date of filing: 12.10.2010
(51) Int. Cl.: G09G 3/28

(54) **Plasma display apparatus**

(30) Priority: 19.10.2009 KR 20090099258
(71) Applicant: SAMSUNG ELECTRONICS CO., LTD., Suwon-si Gyeonggi-do 442-742 (KR)
(72) Inventor: Shon, Young-ki, Gyeonggi-do (KR); Kim, Hong-jin, Gyeonggi-do (KR)
(74) Representative: D'Halleweyn, Nele Veerle Trees Gertrudis

(57) **Abstract**

A plasma display apparatus is provided, the plasma display apparatus including: a display panel; a cable which is connected to an X electrode and a Y electrode of the display panel; and an integrated driving unit which transmits an X driving signal to the X electrode and a Y driving signal to the Y electrode. Therefore, the structure of a driving circuit can be simplified.

## Description

Apparatuses and methods consistent with exemplary embodiments relate to a plasma display apparatus, and more particularly, to a plasma display apparatus in which an X driving circuit and a Y driving circuit are integrated into a single driving circuit.

Flat display apparatuses are generally used for portable devices and are rapidly replacing cathode ray tube (CRT) displays due to development of large display technologies in the large display field.

Plasma display panels (PDPs) are a kind of flat display apparatuses which display text or graphics using light emitted from plasma generated by gas discharge. Compared with other kinds of flat display apparatuses, PDPs have high luminance, a high efficiency of light emission, and a wide viewing angle, and is thus widespread today.

The PDP includes an X driving circuit, a Y driving circuit, and an address driving circuit. The X driving circuit is connected to X electrodes and transmits the driving voltage to the X electrodes so as to operate the panel. The Y driving circuit is connected to Y electrodes and transmits the driving voltage to the Y electrodes so as to operate the panel. In particular, the X driving circuit and the Y driving circuit perform a sustain discharge of a selected pixel by alternately inputting a sustain voltage to the X electrodes and the Y electrodes. The address driving circuit transmits a data signal to address electrodes so as to operate the panel.

As described above, since the PDP has the plurality of driving circuits, a structure thereof is complicated and a manufacturing cost is expensive. Therefore, there is a need for methods of simplifying the structure of the PDP.

Exemplary embodiments address at least the above problems and/or disadvantages and other disadvantages not described above. Also, an exemplary embodiment is not required to overcome the disadvantages described above, and an exemplary embodiment may not overcome any of the problems described above.

Exemplary embodiments provide a plasma display apparatus in which an X driving circuit and a Y driving circuit are integrated into a single driving circuit.

According to an aspect of an exemplary embodiment, there is provided a plasma display apparatus including: a display panel in which an X electrode and a Y electrode are arranged; a cable which is connected to the X electrode and the Y electrode; and an integrated driving unit which transmits an X driving signal to the X electrode and a Y driving signal to the Y electrode through the cable to drive the display panel.

The cable may include a plurality of cables, and the plurality of cables may pass through an edge of the display panel and may be connected to the integrated driving unit.

The cable may include a plurality of cables, a plurality of X electrodes and a plurality of Y electrodes may be arranged in the display panel, and each of the plurality of cables may be connected to at least one X electrode and at least one Y electrode.

A plurality of X electrodes and a plurality of Y electrodes may be arranged in the display panel, and the integrated driving unit may directly transmit the X driving signal to only one of the plurality X electrodes, and directly transmit the Y driving signal to each of the plurality X electrodes.

At least one ends of at least two of the plurality of X electrodes may be connected to each other so that the at least two X electrodes receive the X driving signal transmitted to the one of the plurality of X electrodes.

The cable may be a flexible printed circuit (FPC) cable.

A plurality of X electrodes and a plurality of Y electrodes may be arranged in the display panel, and two X electrodes may be formed between two adjacent Y electrodes, and two Y electrodes may be formed between two adjacent X electrodes.

A plurality of X electrodes and a plurality of Y electrodes may be arranged in the display panel, and some of the plurality of X electrodes may be connected to the cable through an electrode pad, and the remaining X electrodes may be connected to the some of the plurality of X electrodes which are connected to the cable through the electrode pad.

A plurality of X electrodes and a plurality of Y electrodes may be arranged in the display panel, and some of the plurality of X electrodes may be used as aging electrodes for aging, and the remaining X electrodes may be connected to the aging electrodes so as to be aged.

Among the plurality of X electrodes, the aging electrodes may be connected to an aging clip for the X electrodes so as to be aged based on a voltage received from the aging clip for the X electrodes, and the plurality of Y electrodes may be connected to an aging clip for the Y electrodes at one ends on which the aging electrodes are not disposed from among both ends of the Y electrodes so as to be aged based on a voltage received from the aging clip for the Y electrodes.

According to an aspect of another exemplary embodiment, there is provided a driving apparatus to provide driving signals to electrodes of a display panel, the driving apparatus including: an X-Y integrated driving circuit in which an X driving circuit and a Y driving circuit are integrated, and which transmits an X driving signal to a first X electrode of a plurality of X electrodes of the display panel and a Y driving signal to a Y electrode of a plurality of Y electrodes of the display panel through a cable so as to drive the display panel.

According to an aspect of another exemplary embodiment, there is provided a driving method of a display panel, the driving method including: transmitting, from an integrated driving circuit, an X driving signal to an X electrode of the display panel; and transmitting, from the integrated driving circuit, a Y driving signal to a Y electrode of the display panel.

### BRIEF DESCRIPTION OF THE DRAWINGS

The above and/or other aspects will be more apparent by describing certain exemplary embodiments with reference to the accompanying drawings, in which:

FIG. 1 is a side-sectional view of a plasma display apparatus according to an exemplary embodiment;

FIG. 2 is a partially exploded perspective view of a plasma display apparatus according to an exemplary embodiment;

FIG. 3 illustrates a driving circuit which is attached to a rear surface of a base chassis according to an exemplary embodiment;

FIG. 4 illustrates a method for operating a plasma display apparatus according to an exemplary embodiment;

FIGs. 5A to 5C illustrate detailed structures of a discharge cell according to an exemplary embodiment;

FIG. 6 illustrates a form of a connection between electrodes and an FPC cable according to an exemplary embodiment;

FIGs. 7A to 7D illustrate forms of connection between electrodes and an FPC cable according to other exemplary embodiments of the present invention;

FIG. 8 illustrates a form of electrodes for aging according to an exemplary embodiment; and

FIG. 9 illustrates a connection of an aging clip according to an exemplary embodiment.

### DETAILED DESCRIPTION OF EXEMPLARY EMBODIMENTS

Certain exemplary embodiments will now be described in greater detail with reference to the accompanying drawings. In the following description, like drawing reference numerals are used for like elements, even in different drawings. The matters defined in the description, such as detailed construction and elements, are provided to assist in a comprehensive understanding of the exemplary embodiments. However, the exemplary embodiments can be practiced without those specifically defined matters. Also, well-known functions or constructions are not described in detail since they would obscure the exemplary embodiments with unnecessary detail.

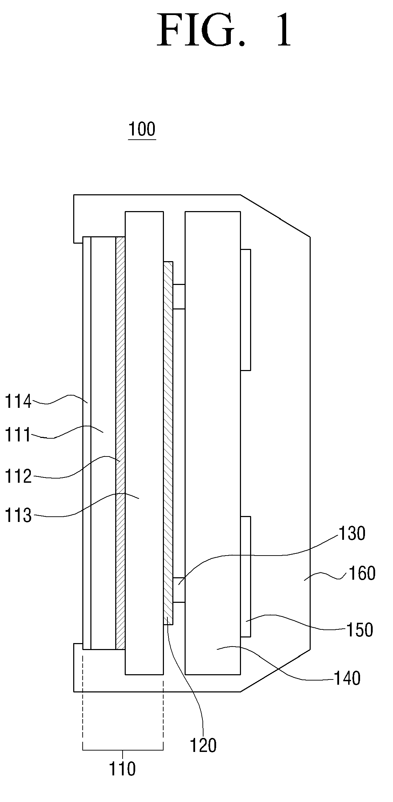

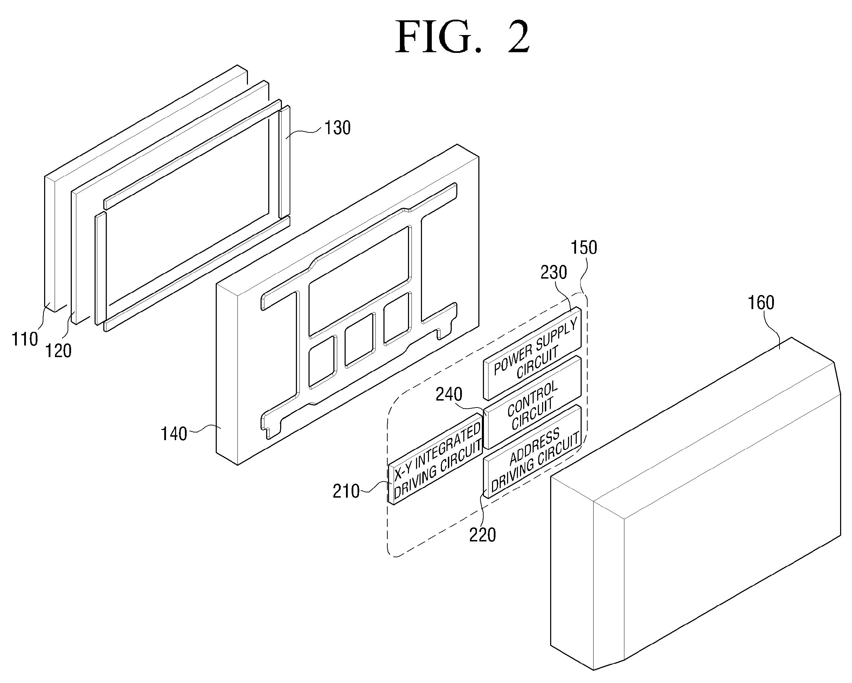

FIG. 1 is a side-sectional view of a plasma display apparatus 100 according to an exemplary embodiment, and FIG. 2 is a partially exploded perspective view of the plasma display apparatus 100. The plasma display apparatus 100 meets electromagnetic wave standard for electromagnetic interference (EMI) and provides a viewer with viewable images.

Referring to FIGs. 1 and 2, the plasma display apparatus 100 may include a panel 110, a thermal spread sheet (TSS) 120, a gasket 130, a base chassis 140, a driving circuit 150, and a cover 160.

The panel 110 realizes an image by exciting a fluorescent substance using vacuum ultraviolet rays generated by an internal gas electric discharge. The panel 110 may include an upper panel 111 and a lower panel 113. The edge of the upper panel 111 is connected to the edge of the lower panel 113 using a sealing substance 112 such as frit so as to form a single panel 110. A plurality of discharge cells are formed in a space between the upper panel 111 and the lower panel 113 sealed by the sealing substance 112, and each discharge cell is filled with neon (Ne) and xenon (Xe).

In each discharge cell, electrodes which are connected to the driving circuit 150 are arranged. If the driving circuit 150 supplies the voltage to the electrodes, the plasma display apparatus 100 operates. A detailed description of a method for operating the plasma display apparatus 100 according to an exemplary embodiment is given below.

A glass filter 114 is attached to or coated on an upper side of the upper panel 111 for surface reflection prevention, color correction, near infrared ray absorption, electromagnetic interference (EMI) blocking, etc. The glass filter 114 may be formed in a single filter layer or in a plurality of filter layers which differ from each other according to their operation.

A filter layer for surface reflection prevention may prevent the viewer from viewing a glare and prevent scratches and static electricity on the surface. A filter layer for color correction and color purity improvement prevents light having a wavelength between 580 nm and 590 nm from being emitted to the viewer so as to enhance a color correction range and correct white deviation.

A filter layer for near infrared ray absorption prevents light having a wavelength between 800 nm and 1200 nm from being emitted to the viewer so as to prevent malfunctioning of the plasma display apparatus 100 by interference with a wavelength band of a remote control. A filter layer for EMI blocking reduces EMI emitted toward the front surface of the panel 110.

The TSS 120 is attached onto the rear surface of the lower panel 113 so as to prevent a degradation of image quality caused by transmitting heat generated in the plasma display apparatus 100 only to a specific portion of the panel 110. That is, the TSS 120 is used to dissipate the heat from the plasma display apparatus 100.

In addition, the TSS 120 is connected to the base chassis 140 through the gasket 130 so as to block EMI. That is, since energy of a driving wave causing discharge emits EMI using the electrodes on the panel 110 as an antenna by the voltage and the current which are applied to the X electrodes and the Y electrodes, the TSS 120 is connected to the base chassis 140 through the gasket 130 so as to reduce EMI emission. The TSS 120 may be implemented as an E-Graf.

In this exemplary embodiment, the TSS 120 is used to dissipate the heat and block the EMI, but this is merely an example. Even when a sheet to dissipate the heat and a sheet to block the EMI are separately provided, a technical aspect of the exemplary embodiment can be applied. Furthermore, if it is not necessary to dissipate the heat or if the heat can be dissipated by other methods, it is also possible to provide only a sheet to block the EMI.

In order to connect the TSS 120 with the base chassis 140, the gasket 130 may be formed of a bondable substance. In particular, in order to transmit the electric current from the TSS 120 to the base chassis 140, the gasket 130 may be formed of a conductive material such as a metal fabric. That is, the gasket 130 connects the TSS 120 and the base chassis 140 electrically so that the base chassis 140 can be used as the ground and a return path can be formed between the TSS 120 and the base chassis 140.

The base chassis 140 accommodates the driving circuit 150, and grounds the electric current generated by the driving circuit 150.

As illustrated in FIG. 2, the driving circuit 150 may include an X-Y integrated driving circuit 210, an address driving circuit 220, a power supply circuit 230, and a control circuit 240. The X-Y integrated driving circuit 210 and the address driving circuit 220 transmit an X electrode driving signal, a Y electrode driving signal, and an address electrode driving signal to the X electrodes, the Y electrodes, and the address electrodes, respectively, so as to drive the panel 110.

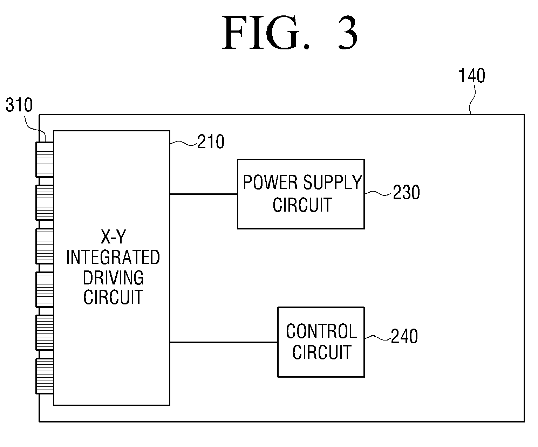

The driving circuit 150 is disposed on the rear surface of the base chassis 140. A detailed description of the driving circuit 150 disposed on the rear surface of the base chassis 140 according to an exemplary embodiment is given with reference to FIG. 3.

FIG. 3 illustrates the driving circuit 150 which is attached to the rear surface of the base chassis 140 according to an exemplary embodiment. More specifically, FIG. 3 is a drawing illustrating the rear surface of the base chassis 140. In FIG. 3, the address driving circuit 220 is not illustrated for convenience of description.

As illustrated in FIG. 3, the X-Y integrated driving circuit 210 is disposed on one side of the rear surface of the base chassis 140, and is connected to the electrodes on the panel 110 through a plurality of flexible printed circuit (FPC) cables 310. The relationship of the connection between the FPC cables 310 and the electrodes according to an exemplary embodiment is described in detail later.

The X-Y integrated driving circuit 210 is also connected to the power supply circuit 230 and the control circuit 240, and drives the panel 110 using the power received from the power supply circuit 230 and a control signal received from the control circuit 240.

Since the X-Y integrated driving circuit 210 in which an X driving circuit and a Y driving circuit are integrated is provided, the structure of the driving circuit 150 can be simplified.

As illustrated in FIGs. 1 and 2, the cover 160 covers a portion of the front surface of the panel 110, and the side and the rear surface of the panel 110 so as to prevent damage of the panel 110 and the driving circuit 150. The cover 160 may block EMI emitted from the back of the plasma display apparatus 100, and may thus be formed of a conductive material.

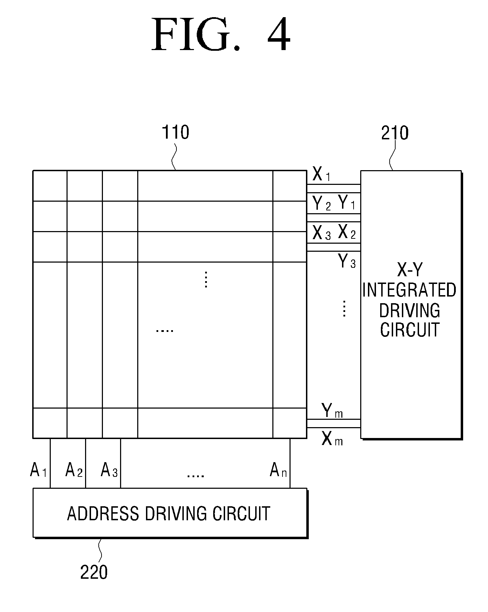

FIG. 4 illustrates a method for operating the plasma display apparatus 100 according to an exemplary embodiment. In particular, FIG. 4 illustrates the front surface of the panel 110. For convenience of description, the X-Y integrated driving circuit 210 and the address driving circuit 220 which are disposed behind the panel 110 are illustrated in FIG. 4 to the right of the panel 110 and under the panel 110, respectively.

The panel 110 includes a plurality of pixels arranged in matrix form. In each pixel, an X electrode, a Y electrode, and an address electrode are provided. The panel 110 is operated in an address display separate (ADS) operating method in which the voltage is transmitted to each electrode so that each pixel emits light. In the ADS operating method, each sub-field of the panel 110 is divided into a reset section, an address section, and a sustain section.

In the ADS operating method, a single frame is divided into a plurality of sub-fields corresponding to bits of video data, and each sub-field is divided into a reset section, an address section, and a sustain discharge section. In each sub-field, the reset section and the address section are set identically, and the sustain discharge section is set to have a different weight. Therefore, in the ADS operating method, gradation of video data can be expressed by a combination of the sustain discharge sections which sustain discharge according to the video data.

The reset section eliminates a previous wall charge state and sets up wall charges to perform the next address discharge stably. The address section selects turned-on cells and turned-off cells and stacks wall charges in the turned-on cells (i.e., addressed cells). The sustain discharge section alternately transmits the sustain voltage to the X electrode and the Y electrode and performs discharge to display an image on the addressed cells.

The X-Y integrated driving circuit 210 is connected to the X electrodes and the Y electrodes and transmits the driving voltage to the X electrodes and the Y electrodes so that the panel 110 can operate. In particular, the X-Y integrated driving circuit 210 performs a sustain discharge of a selected pixel by alternately inputting the sustain voltage to the X electrodes and the Y electrodes.

The address driving circuit 220 transmits a data signal to select a pixel on which an image is displayed to an address electrode.

The X electrodes and the Y electrodes are at right angles to the address electrodes, and face each other with a discharge space therebetween. The discharge spaces in which the X electrodes, the Y electrodes, and the address electrodes cross one another form the discharge cells.

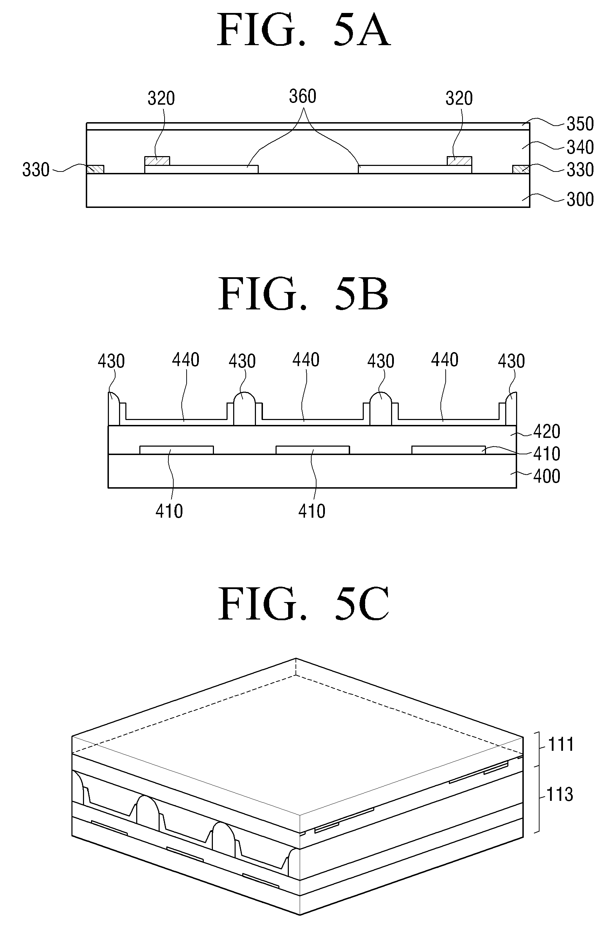

The discharge cell is described in detail with reference to FIGs. 5A to 5C. FIGs. 5A to 5C illustrate a detailed structure of the discharge cell according to an exemplary embodiment.

Referring to FIG. 5A, in order to manufacture the upper panel 111 according to an exemplary embodiment, an upper glass 300 is formed first or provided, and indium tin oxide (ITO) electrodes 360 are patterned on the upper glass 300. The ITO electrode 360 is a kind of transparent electrode which is used to prevent light generated between X electrodes and Y electrodes from being hidden by the opaque X electrodes and the opaque Y electrodes and thereby not being viewed.

After the ITO electrodes 360 are patterned on the upper glass 300, bus electrodes (i.e., the X electrodes and the Y electrodes) 320 are patterned on the ITO electrode 360. The X electrodes and the Y electrodes receive the sustain voltage alternately and perform a sustain discharge for a selected pixel.

After the bus electrodes 320 are patterned on the ITO electrode 360, black stripes 330 are patterned on the upper glass 300. The black stripes 330 are provided between the pixels so as to maintain the separated state between the pixels.

After the black stripe 330 is patterned on the upper glass 300, a dielectric layer 340 and a magnesium oxide (MgO) protective layer 350 are disposed thereon. The dielectric layer 340 and the MgO protective layer 350 generate plasma stably by maintaining insulation between the address electrodes and the bus electrodes 320, and prevent the electrodes from being eroded by the plasma.

Referring to FIG. 5B, in order to manufacture the lower panel 113 according to an exemplary embodiment, a lower glass 400 is formed first or provided, and address electrodes 410 are patterned on the lower glass 400. The address electrode 410 is used to transmit a data signal to select a pixel to be displayed.

After the address electrodes 410 are patterned on the lower glass 400, the dielectric layer 420 is disposed thereon. As described above, the dielectric layer 420 generates plasma stably by maintaining insulation between the address electrodes 410 and the bus electrodes 320, and prevents the electrodes from being eroded by the plasma.

Partitions 430 are provided on the dielectric layer 420. The partitions 430 block a fluorescent substance so that a red ® pixel, a green (G) pixel, and a blue (B) pixel can be distinguished.

After the partitions 430 are formed on the dielectric layer 420, a fluorescent substance 440 is provided between the partitions 430, and the sealing substance 112 such as frit is filled therein. By this exemplary process, the lower panel 113 is manufactured.

After the upper panel 111 and the lower panel 113 are manufactured, assembly and bonding of the upper panel 111 and the lower panel 113, gas injection, aging, lighting inspection, etc. are performed so that the panel 110 is provided as illustrated in FIG. 5C.

Referring to FIG. 4, an X electrode and a Y electrode are disposed in each discharge cell on the panel 110. Two X electrodes are disposed between two adjacent Y electrodes, and two Y electrodes are disposed between two adjacent X electrodes. In addition, the X electrodes and the Y electrodes are connected to the X-Y integrated driving circuit 210 through the FPC cable 310.

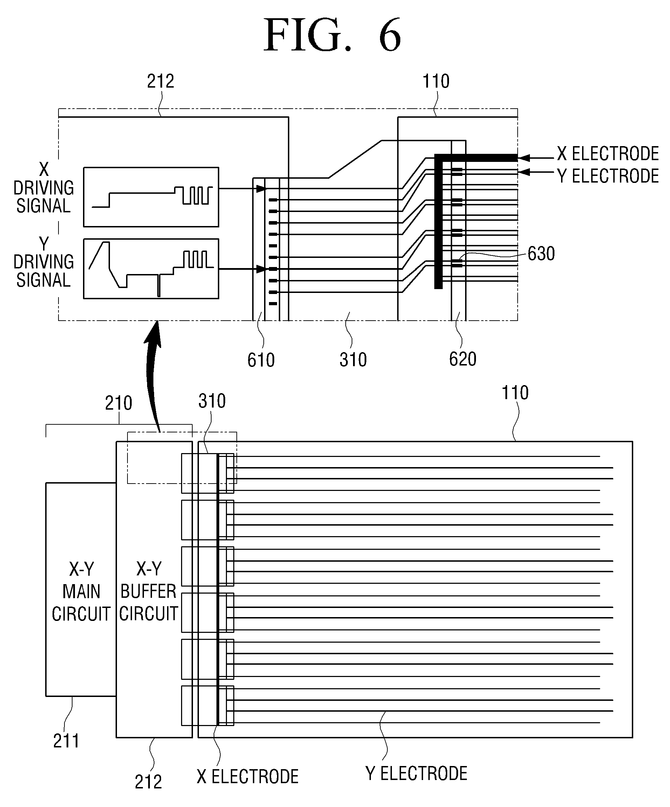

Hereinafter, forms of connection between the electrodes and the FPC cable 310 are described. FIG. 6 illustrates a form of a connection between the electrodes on the panel 110 and the FPC cable 310 according to an exemplary embodiment.

The X-Y integrated driving circuit 210 is connected to the X electrodes and the Y electrodes through the plurality of FPC cables 310. The X-Y integrated driving circuit 210 includes an X-Y main circuit 211 and an X-Y buffer circuit 212.

The X-Y main circuit 211 generates a pulse and transmits the pulse to the X-Y buffer circuit 212. The X-Y buffer circuit 212 transmits the received pulse to a specific scanning electrode.

A scan integrated circuit (IC) is embedded in the X-Y buffer circuit 212 so as to select a scanning electrode and transmit a pulse generated by the X-Y main circuit 211 to the selected scanning electrode. That is, the scan IC selects a scanning electrode according to a scan IC control signal transmitted from the X-Y main circuit 211 to the scan IC, and transmits the pulse to the selected scanning electrode.

Describing a form of connection between the electrodes on the panel 110 and the FPC cable 310 in greater detail, the X-Y buffer circuit 212 is connected to the FPC cable 310 through a connector 610, and the FPC cable 310 is connected to the X electrodes and the Y electrodes through a panel bonding unit 620.

The X-Y buffer circuit 212 generates an X driving signal and transmits the X driving signal to an X electrode through a line which is connected to the X electrode from among the lines of the FPC cable 310. Referring to FIG. 6, there is a single line which is connected to an X electrode from among the lines of a single FPC cable 310. However, the X electrode is connected to other X electrodes, so even though a single line is connected to the X electrode, all the X electrodes can receive an X driving signal from the X-Y buffer circuit 212.

In addition, among the lines of the FPC cable 310, the line to be connected to the X electrode is connected to the X electrode through a pad 630 of the panel bonding unit 620. The pad 630 may be formed by soldering the line of the FPC cable 310 and an electrode together. As described above, since there is a single line which is connected to the X electrode from among the lines of the FPC cable 310, there is also a single 630 pad which is connected to the X electrode.

The X-Y buffer circuit 212 generates a Y driving signal and transmits the Y driving signal to the Y electrodes through lines which are connected to the Y electrodes from among the lines of the FPC cable 310. Referring to FIG. 6, among the lines of a single FPC cable 310, there are as many lines that are connected to the Y electrodes as the number of Y electrodes (i.e., a 1:1 relationship). Accordingly, each Y electrode can receive a respective Y driving signal from the X-Y buffer circuit 212.

In addition, among the lines of the FPC cable 310, the lines to be connected to the Y electrodes are connected to the Y electrodes through pads 630 of the panel bonding unit 620, respectively. As described above, since there are as many lines that are connected to the Y electrodes as the number of Y electrodes from among the lines of the FPC cable 310, there are also as many pads 630 that are connected to the Y electrodes as the number of Y electrodes.

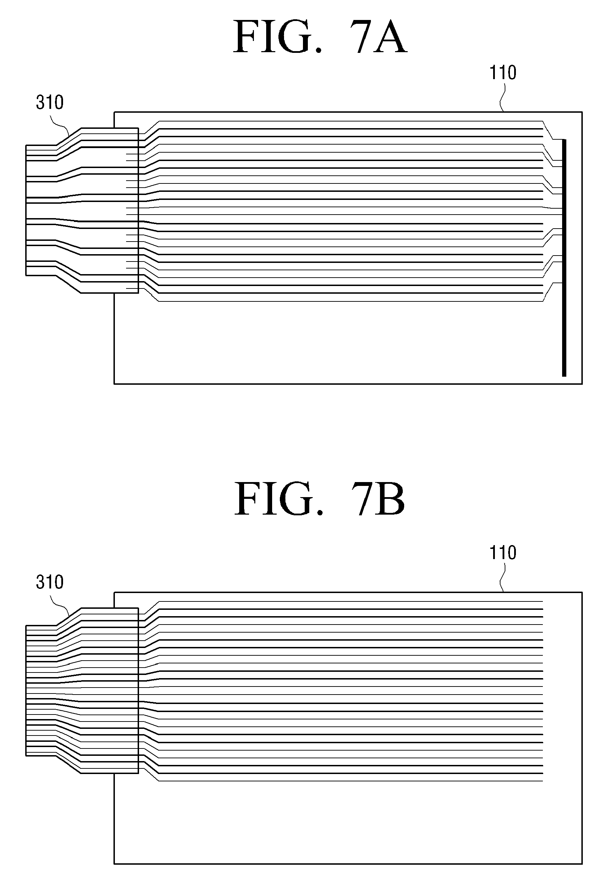

In the above exemplary embodiment, a single line from among the lines of the FPC cable 310 is connected to a single X electrode and the X electrode is connected to other X electrodes, so the X electrodes receives a common X driving signal. In addition, in order to receive the common X driving signal, ends of the X electrodes which are adjacent to the X-Y buffer circuit 212 among both ends of the X electrodes are connected to one another. This is merely an example for convenience of description. It is understood that a technical aspect of the exemplary embodiments is not limited thereto. For example, FIGs. 7A to 7D illustrate forms of connection between the electrodes and the FPC cable 310 according to other exemplary embodiments.

Referring to FIG. 7A, among both ends of the X electrodes, ends of the X electrodes which are farther from the X-Y buffer circuit 212 are connected to one another, and only one of the X electrodes is connected to the X-Y buffer circuit 212 through the FPC cable 310.

Referring to FIG. 7B, the X electrodes are not connected to one another but are connected to the X-Y buffer circuit 212 through the FPC cable 310.

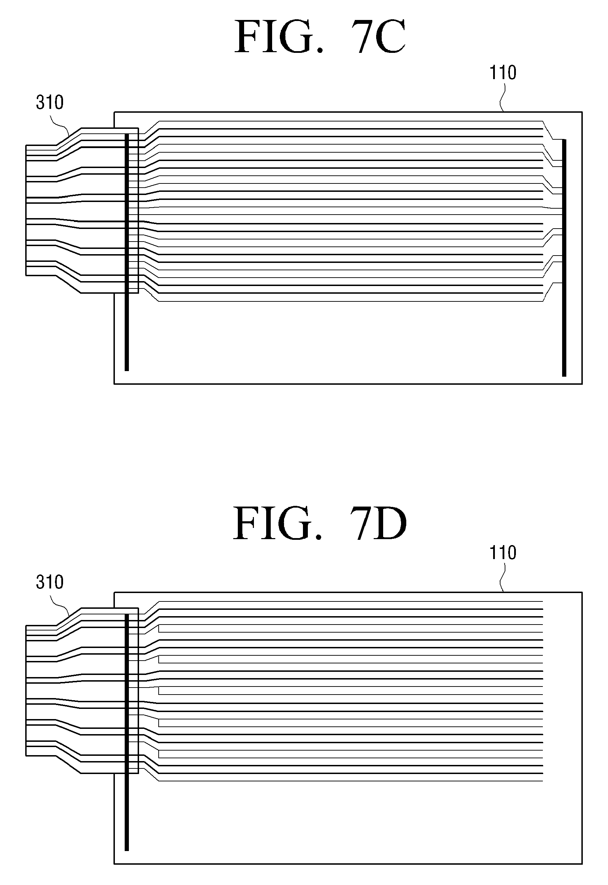

Referring to FIG. 7C, first ends of the X electrodes are connected to one another, second ends of the X electrodes are connected to one another, and only one of the X electrodes is connected to the X-Y buffer circuit 212 through the FPC cable 310.

Referring to FIG. 7D, among both ends of the X electrodes, ends of the X electrodes which are adjacent to the X-Y buffer circuit 212 are connected to one another, and only one of the X electrodes is connected to the X-Y buffer circuit 212 through the FPC cable 310. The form of connection in FIG. 7D is similar to that in FIG. 7A. However, in FIG. 7D, every two X electrodes are connected to each other, so the X electrodes in FIG. 7D are different from the X electrodes in FIG. 7A. If the X electrodes are implemented in this exemplary manner, a space in which the electrodes and the FPC cable 310 are connected to each other may be relaxed. As in these exemplary embodiments, an X driving signal to drive an X electrode can be transmitted to each of the X electrodes.

As described above, after the upper panel 111 and the lower panel 113 are manufactured, the panel 110 is formed by performing the assembly and bonding of the upper panel 111 and the lower panel 113, gas injection, aging, lighting inspection, etc.

The plasma display apparatus 100 is manufactured after passing through a plurality of processes. The plurality of processes are simply divided into a pre-process, a post-process, and a module process. The pre-process is a process for forming a plurality of films on the panel 110, and the post-process is a process for performing bonding of the upper panel 111 and the lower panel 113, air discharge, discharge gas injection, tip-off, aging, and inspection.

In the post-process, the aging is a process for transmitting the electric current to the electrodes, driving the panel 110, and eliminating impurities from the panel 110, thereby stabilizing operating characteristics of the panel 110. More specifically, in the aging process, discharge cells are continuously discharged by biasing a high voltage which is greater than a rated voltage to the panel 110, so that operating characteristics of the discharge cells having different physical characteristics can become uniform and stabilized.

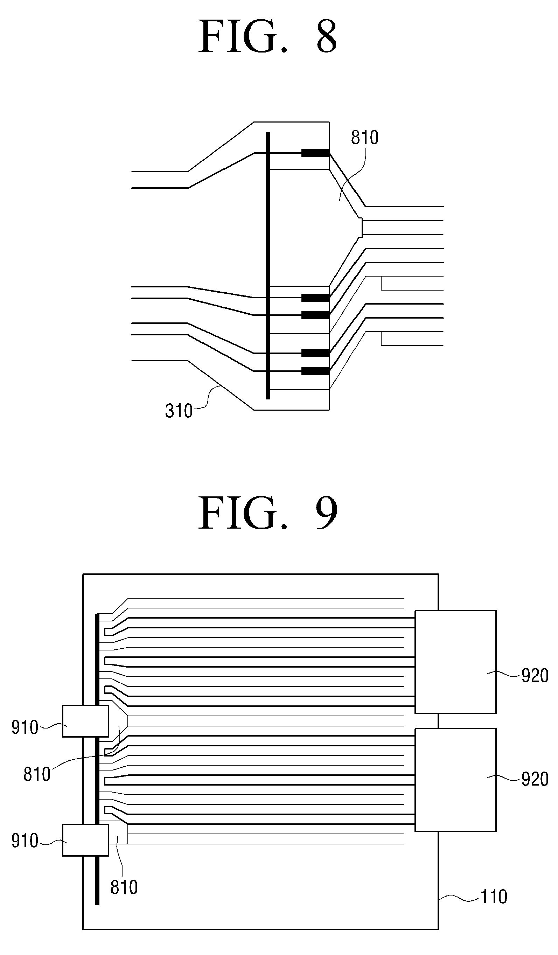

For aging, some of the X electrodes may operate as aging electrodes. Detailed description is given with reference to FIGs. 8 and 9. FIG. 8 illustrates a form of electrodes for aging according to an exemplary embodiment.

As described above, first ends of the X electrodes are connected to one another in the FPC cable 310 according to an exemplary embodiment, and each of the Y electrodes are connected to the X-Y buffer circuit 212 through the FPC cable 310. In this case, some of the X electrodes have an electrode exposed portion 810 for aging. The electrode exposed portion 810 is a portion to be connected to an aging clip and thus is manufactured to have a size large enough to be connected to the aging clip.

The electric current is transmitted to the electrode exposed portion 810 through the aging clip and is thus transmitted to the X electrodes, so that the panel 110 can operate. Consequently, impurities are eliminated from the panel 110.

As described with respect to the aging process for the X electrodes, an aging process for the Y electrodes is performed. However, since an area occupied by the electrode exposed portion 810 for aging of the X electrodes is large, aging of the Y electrodes is performed in an area which is different from the area for aging of the X electrodes. Detailed description is given with reference to FIG. 9.

FIG. 9 illustrates connection of an aging clip according to an exemplary embodiment. As illustrated in FIG. 9, if an electrode exposed portion 810 for aging of the X electrodes is disposed on the left side of the panel 110, one or more aging clips 910 for aging of the X electrodes are connected to the electrode exposed portion 810 on the left side of the panel 110.

Since an area occupied by the electrode exposed portion 810 for aging of the X electrodes and an area occupied by the aging clip 910 for aging of the X electrodes are large, one or more aging clips 920 of the Y electrodes are disposed opposite the aging clip 910 of the X electrodes as illustrated in FIG. 9. However, the Y electrodes have a separate electrode exposed portion, and the aging clip 920 of the Y electrodes is connected directly to the Y electrodes.

As can be appreciated from the above description of the X-Y integrated driving circuit 210, the structure of the plasma display apparatus 100 can be simplified.

The foregoing exemplary embodiments are merely exemplary and are not to be construed as limiting the present invention. The present teaching can be readily applied to other types of apparatuses. Also, the description of the exemplary embodiments is intended to be illustrative, and not to limit the scope of the claims, and many alternatives, modifications, and variations will be apparent to those skilled in the art.

## Claims

1. A plasma display apparatus, comprising:
a display panel (110) in which an X electrode and a Y electrode are arranged;
a cable (310) which is connected to the X electrode and the Y electrode; and
an integrated driving unit (210) which transmits an X driving signal to the X electrode and a Y driving signal to the Y electrode through the cable so as to drive the display panel.

2. The plasma display apparatus according to claim 1, wherein the cable comprises a plurality of cables, and the plurality of cables pass through one of edges of the display panel and are connected to the integrated driving unit.

3. The plasma display apparatus according to claim 1 or claim 2, wherein the cable comprises a plurality of cables, a plurality of X electrodes and a plurality of Y electrodes being arranged in the display panel, and each of the plurality of cables is connected to at least one X electrode and at least one Y electrode.

4. The plasma display apparatus according to any one of claims 1 to 3, wherein there a plurality of X electrodes and a plurality of Y electrodes are arranged in the display panel, and the integrated driving unit is configured to transmit the X driving signal to one of the plurality of X electrodes, and to transmit the Y driving signal to each of the plurality X electrodes.

5. The plasma display apparatus according to claim 4, wherein at least one ends of at least two of the plurality of X electrodes are connected to each other so that the at least two X electrodes receive the X driving signal transmitted to the one of the plurality of X electrodes.

6. The plasma display apparatus according to any one of claims 1 to 5, wherein the cable is a flexible printed circuit (FPC) cable.

7. The plasma display apparatus according to any one of claims 1 to 6, wherein a plurality of X electrodes and a plurality of Y electrodes are arranged in the display panel, and two X electrodes are formed between two adjacent Y electrodes, and two Y electrodes are formed between two adjacent X electrodes.

8. The plasma display apparatus according to any one of claims 1 to 7, wherein a plurality X electrodes and a plurality of Y electrodes are arranged in the display panel, some of the plurality of X electrodes being connected to the cable through an electrode pad, and the remaining X electrodes being connected to the some of the plurality of X electrodes which are connected to the cable through the electrode pad.

9. The plasma display apparatus according to any one of claims 1 to 8, wherein a plurality X electrodes and a plurality of Y electrodes are arranged in the display panel, and some of the plurality of X electrodes are used as aging electrodes for aging, and remaining X electrodes are connected to the aging electrodes so as to be aged.

10. The plasma display apparatus according to claim 9, wherein:
among the plurality of X electrodes, the aging electrodes are connected to an aging clip for the X electrodes so as to be aged based on a voltage received from the aging clip for the X electrodes, and
the plurality of Y electrodes are connected to an aging clip for the Y electrodes at one ends on which the aging electrodes are not disposed from among both ends of the Y electrodes so as to be aged based on a voltage received from the aging clip for the Y electrodes.
